# EUROPEAN PATENT APPLICATION

(11) **EP 4 611 039 A1**
(43) Date of publication of application: **03.09.2025**
(21) Application number: 23890423.9
(22) Date of filing: 28.09.2023
(51) Int. Cl.: H01L 25/16

(54) **POWER MODULE AND DEVICE**

(30) Priority: 17.11.2022 CN 202211442177; 17.11.2022 CN 202211458029; 17.11.2022 CN 202211442180
(71) Applicant: Hisense Home Appliances Group Co., Ltd., Foshan, Guangdong 528303 (CN)
(72) Inventor: ZHOU, Wenjie, Foshan, Guangdong 528303 (CN); CHENG, Zhangming, Foshan, Guangdong 528303 (CN); LI, Zhengkai, Foshan, Guangdong 528303 (CN); BIE, Qingfeng, Foshan, Guangdong 528303 (CN); XIE, Dilin, Foshan, Guangdong 528303 (CN)
(74) Representative: Casalonga
(86) International application number: PCT/CN2023/122947
(87) International publication number: WO 2024/103986

(57) **Abstract**

A power module, comprising: a packaging body; a power chip, a control chip, and a heat dissipation substrate which are arranged in the packaging body; and a power pin and a control pin respectively led out from a first side surface and a second side surface of the packaging body. The power chip is arranged on the heat dissipation substrate. The bottom surface of the heat dissipation substrate is flush with the bottom surface of the packaging body and is exposed outside the packaging body. The packaging body comprises a resin injection portion and a first step portion. The first step portion is located on a side of the part of the power pin extending out of the packaging body, wherein the side is close to the bottom surface of the packaging body. In the width direction of the packaging body, the side surface of the first step portion is closer to the heat dissipation substrate than the first side surface; and in the thickness direction of the packaging body, the step surface of the first step portion is closer, than the bottom surface of the packaging body, to the part of the power pin extending out of the packaging body, and the distance from the step surface of the first step portion to the bottom surface of the packaging body is less than the distance from the resin injection portion to the bottom surface of the packaging body.

## Description

This application claims priority to Chinese Patent Application No. 202211442177.8, filed on November 17, 2022; Chinese Patent Application No. 202211458029.5, filed on November 17, 2022; and Chinese Patent Application No. 202211442180.X, filed on November 17, 2022, which are incorporated herein by reference in their entireties.

### TECHNICAL FIELD

The present disclosure relates to the technical field of electronic devices, and in particular, to a power module and a device.

### BACKGROUND

Power modules (PM) have characteristics of high current density, low saturation voltage, low driving power, high switching frequency, high functional integration level, convenience of use and good reliability. The power modules may be widely applied to many fields such as consumer electronics, household appliances, automobiles, rail transit, industrial equipment, new and renewable sources of energy, smart grid, etc. Generally, power modules use resin to package power chips and control chips, so that the characteristic of a high integration level of the power module may be achieved.

### SUMMARY

In one aspect, a power module is provided. The power module includes a packaging body, a power chip, a control chip, a power pin, a control pin and a heat dissipation substrate. The power chip is electrically connected to the control chip and both are disposed in the packaging body. The power pin is led out from a first side of the packaging body and electrically connected to the power chip. The control pin is led out from a second side of the packaging body and electrically connected to the control chip. The first side and the second side are disposed opposite to each other. The heat dissipation substrate is located in the packaging body, and the power chip is disposed on the heat dissipation substrate. A bottom surface of the heat dissipation substrate is flush with a bottom surface of the packaging body and exposed outside the packaging body.

The packaging body includes a resin injection portion. In a thickness direction of the power module, a distance from the resin injection portion to the bottom surface of the packaging body is greater than a distance from a top surface of the power chip to the bottom surface of the packaging body.

The packaging body further includes a recessed first step portion. The first step portion is located on a side of a portion of the power pin extending toward outside of the packaging body proximate to the bottom surface of the packaging body, and in the thickness direction of the power module, a distance from the step surface of the first step portion to the bottom surface of the packaging body is less than the distance from the resin injection portion to the bottom surface of the packaging body.

In another aspect, a device is provided. The device includes a controller and the power module provided in the embodiments, and the power module is connected to the controller.

### BRIEF DESCRIPTION OF THE DRAWINGS

FIG. 1A is a schematic sectional view of a power module in the related art taken along a width direction;
FIG. 1B is a schematic diagram showing a structure of a main structure of a power module packaged by transfer molding in the related art;
FIG. 2A is a schematic sectional view of a power module taken along a width direction, in accordance with some embodiments;
FIG. 2B is a schematic diagram showing a structure of a main structure of a power module packaged by transfer molding, in accordance with some embodiments;
FIG. 2C is a schematic sectional view of a power module taken along a width direction, in accordance with some embodiments;
FIG. 2D is a schematic sectional view of a power module taken along a width direction, in accordance with some embodiments;
FIG. 2E is a schematic sectional view of a power module taken along a width direction, in accordance with some embodiments;
FIG. 3 is a side view of a power module, in accordance with some embodiments;
FIG. 4 is a top view of a power module, in accordance with some embodiments;
FIG. 5 is a perspective view of a power module, in accordance with some embodiments;
FIG. 6 is a top view of a power module, in accordance with some embodiments;
FIG. 7 is a perspective view of a power module, in accordance with some embodiments;
FIG. 8 is a top view of a power module, in accordance with some embodiments;
FIG. 9 is a bottom view of a power module, in accordance with some embodiments;
FIG. 10 is a partial enlarged view of the power module in FIG. 9;
FIG. 11 is a perspective view of a power module, in accordance with some embodiments;
FIG. 12 is a bottom view of a power module, in accordance with some embodiments;
FIG. 13 is a side view of a power module, in accordance with some embodiments;
FIG. 14 is a top view of a power module, in accordance with some embodiments;
FIG. 15 is a partial enlarged view of the region A1 of the power module in FIG. 14;
FIG. 16 is a schematic diagram showing a structure of a power module, in accordance with some embodiments;
FIG. 17 is a partial enlarged view of the region B1 of the power module in FIG. 16;
FIG. 18 is a partial enlarged view of the region B1 of the power module in FIG. 16; and
FIG. 19 is a schematic diagram showing a structure a device, in accordance with some embodiments.

### DETAILED DESCRIPTION

Some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, the terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. As used in this description and the appended claims, the singular forms "a/an," and "the" also include plural referents unless the content clearly dictates otherwise. In the description of the embodiments of the present disclosure, the term "a/the plurality of" means two or more unless otherwise specified.

In the description of some embodiments, the expression "connected", and derivative thereof may be used. For example, the term "connected" may be used in the description of some embodiments to indicate that two or more components are in direct physical or electrical contact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

The phrase "applicable to" or "configured to" used herein means an open and inclusive expression, which does not exclude devices that are applicable to or configured to perform additional tasks or steps.

The term "about", "substantially", and "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

Exemplary embodiments are described herein with reference to sectional views and/or plan views as idealized exemplary drawings. In the accompanying drawings, thicknesses of layers and regions are enlarged for clarity. The exemplary embodiments of the present disclosure should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in devices, and are not intended to limit the scope of the exemplary embodiments.

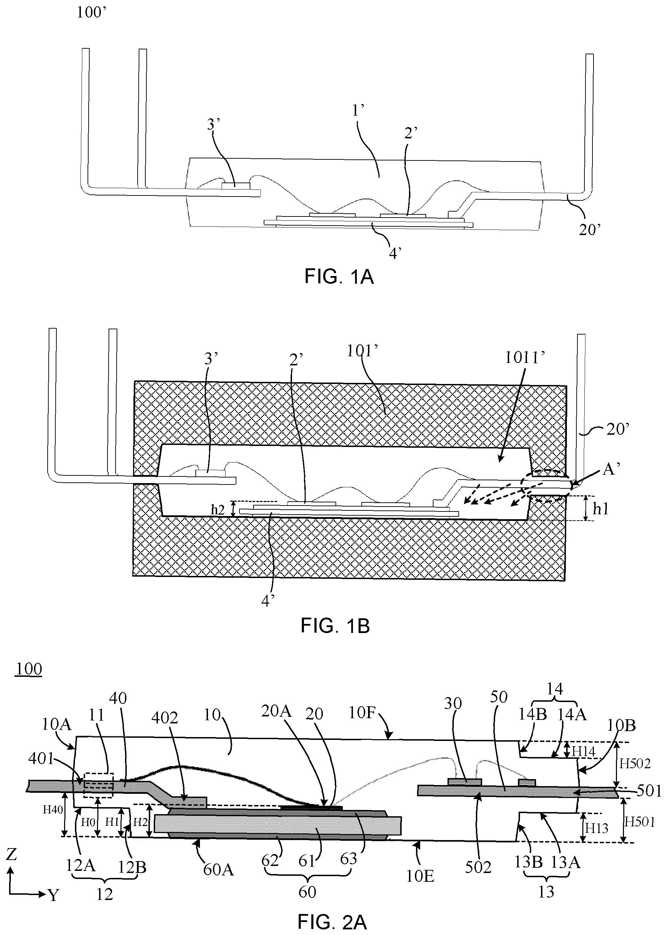

In the related art, as shown in FIG. 1A, a power module (PM) 100' integrates and packages, for example, a power chip 2' and a control chip 3' together through a packaging body 1'. When the power module 100' is operating, a large current flows through the power chip 2', resulting in a large amount of heat generated by the power module 100'. Therefore, in order to ensure the effectiveness of the power module, the power module 100' further includes a heat dissipation substrate 4' for dissipating heat from the power chip 2'. The heat dissipation substrate 4' is usually disposed at a bottom of the power module 100', and a bottom surface of the heat dissipation substrate 4' is exposed from a bottom surface of the packaging body 1', so that the heat dissipation effect is improved.

Transfer molding is usually used for packaging. As shown in FIG. 1B, a main structure of the power module 100', such as the power chip 2', the control chip 3', the heat dissipation substrate 4' and a lead frame, is placed in a cavity 1011' of a mold 101'. Then liquid packaging resin is injected into the cavity 1011' of the mold. The mold 101' is disassembled after the packaging resin cures, so that the power module 100' shown in FIG. 1A is obtained.

However, in the related art, as shown in FIG. 1B, the mold has an upper housing and a lower housing, which are buckled together to form the internal cavity. A power pin 20' is led out from the buckled position between the upper housing and the lower housing. A resin injection opening A' for injecting the packaging resin into the cavity 1011' of the mold is usually disposed on a side of the mold 101' from which the corresponding power pin 20' is led out, and located near the buckled position between the upper housing and the lower housing. For example, in a thickness direction of the mold, a height h1 of the resin injection opening is substantially equal to or slightly higher than or slightly lower than a height of the position where the power pin 20' is led out of the packaging body 1'. Moreover, the height h1 of the resin injection opening is higher than a height h2 of an upper surface of the power chip 2' disposed on the heat dissipation substrate 4', so as to ensure that the resin may completely package the power chip 2; in other words, the height h1 of the resin injection opening is higher than a height of an upper surface of the heat dissipation substrate 4'. Therefore, when the packaging resin is injected, it will rush toward the heat dissipation substrate 4' in an inclined downward direction (e.g., directions shown by the dashed arrows in FIG. 1B), and generate a large impact force on the heat dissipation substrate 4', which may easily cause displacement defects in the heat dissipation substrate 4' and affect the electrical safety and stability of the power module.

On this basis, a power module is provided in embodiments of the present disclosure. As shown in FIGS. 2A to 2E, a main structure of the power module 100 includes a power chip 20, a control chip 30, a power pin 40 electrically connected to the power chip 20, a control pin 50 electrically connected to the control chip 30, and a heat dissipation substrate 60. The power pin 40 is used to connect the power chip 20 with an external driving component, and the control pin 50 is used to connect the control chip 30 with an external controller. The power chip 20 is also electrically connected to the control chip 30, and the control chip 30 is used to drive the power chip 20. The power chip 20 is disposed on the heat dissipation substrate 60. The heat dissipation substrate 60 is used to dissipate heat from the power chip 20, so as to ensure the normal operation of the power chip 20, thereby ensuring the effectiveness of the power module 100.

The power module 100 further includes a packaging body 10 for packaging the main structure. The packaging body 10 has a first side 10A and a second side 10B that are oppositely disposed and each extend in a length direction X of the packaging body. A portion (hereinafter referred to as a first portion) 401 of the power pin 40 is led out from the first side 10A of the packaging body 10, and another portion (hereinafter referred to as a second portion) 402 of the power pin 40 is electrically connected to the power chip 20; a portion (hereinafter referred to as a first portion) 501 of the control pin 50 is led out from the second side 10B of the packaging body 10, and another portion (hereinafter referred to as a second portion) 502 of the control pin 50 is electrically connected to the control chip 30. A bottom surface 60A of the heat dissipation substrate is flush with a bottom surface 10E of the packaging body and exposed outside the packaging body 10, so as to improve the heat dissipation effect.

It will be noted that a surface of the heat dissipation substrate 60 on which the power chip 20 is disposed is referred to as a top surface of the heat dissipation substrate 60; a surface of the heat dissipation substrate 60 which is disposed opposite to the top surface of the heat dissipation substrate 60 and on which the power chip is not disposed is referred to as the bottom surface 60A of the heat dissipation substrate 60; a surface of the packaging body 10 on which the heat dissipation substrate 60 is disposed is referred to as a bottom surface 10E of the packaging body 10, and the bottom surface 10E of the packaging body 10 is a heat dissipation surface of the power module 100.

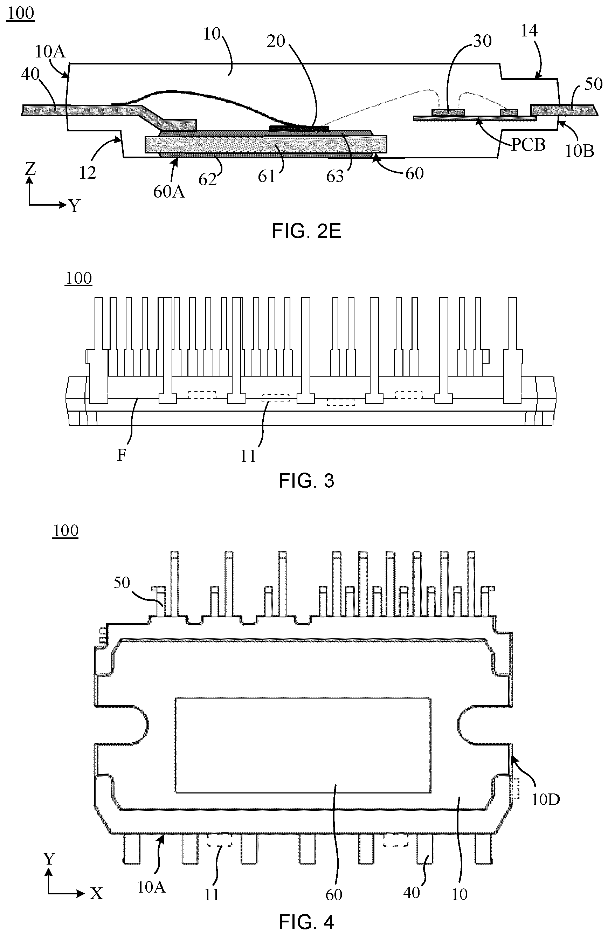

As shown in FIGS. 4 to 9, 11 and 12, there are a plurality of power pins 40 and a plurality of control pins 50, and the length direction X of the packaging body is a direction in which the plurality of power pins 40 or the plurality of control pins 50 are arranged.

As shown in FIGS. 2A, 3, 4, and 13, the packaging body 10 includes a resin injection portion 11.

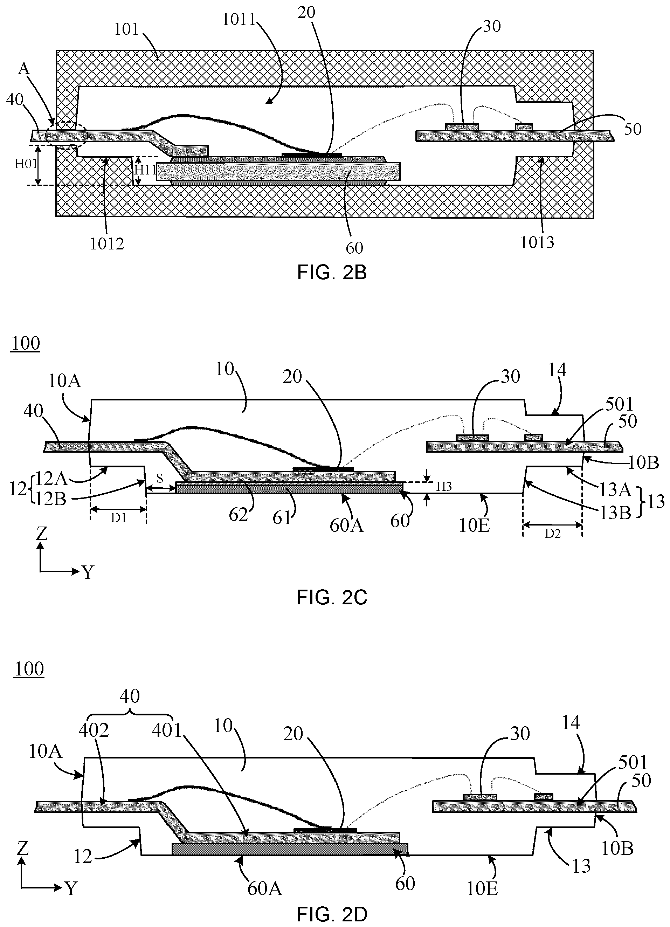

In the embodiments of the present disclosure, the main structure of the power module 100 is packaged by transfer molding, so as to form the packaging body 10. That is to say, as shown in FIG. 2B, the main structure of the power module 100 is placed in the cavity 1011 of the mold 101. The mold 101 has a resin injection opening A. Liquid resin is injected into the cavity 1011 of the mold through the resin injection opening A and fills the space between the main structure of the power module located in the cavity and the cavity walls of the cavity. The packaging body 10 as shown in FIG. 2A may be formed after the resin cures, which covers and protects the power chip 20 and the control chip 30, so that the structural reliability of the power module 100 may be improved.

Therefore, it may be understood that a portion of the formed packaging body 10 corresponding to the resin injection opening A is the resin injection portion 11 of the packaging body 10, and the roughness of the resin injection portion 11 is greater than that of other portions of the packaging body 10.

For example, in a thickness direction Z of the power module 100, a distance H0 from the resin injection portion 11 to the bottom surface 10E of the packaging body is greater than a distance H2 from a top surface 20A (i.e., a surface away from the heat dissipation substrate 60) of the power chip 20 to the bottom surface 10E of the packaging body. In this way, when the resin is injected into the cavity 1011, it may be ensured that the injected resin may submerge the power chip 20, thereby better packaging the power chip 20 in the packaging body 10.

In addition, the packaging body 10 further includes a recessed first step portion 12, and the first step portion 12 is located on a side of the first portion 401 of the power pin 40 extending toward the outside of the packaging body 10 proximate to the bottom surface 10E of the packaging body.

Here, the recessed first step portion 12 means that the first step portion 12 is recessed toward the inside of the packaging body 10. That is to say, the first step portion 12 has a step surface 12A and a side 12B, and in a width direction Y of the packaging body 10, the side 12B of the first step portion 12 is closer to the heat dissipation substrate 60 than the first side 10A of the packaging body 10; and in the thickness direction Z of the packaging body 10, the step surface 12A of the first step portion 12 is closer to the first portion 401 of the power pin 40 extending toward the outside of the packaging body 10 than the bottom surface 10E of the packaging body.

In the thickness direction Z of the power module 100, a distance H1 from the step surface 12A of the first step portion 12 to the bottom surface 10E of the packaging body is less than a distance H40 from the first portion 401 of the power pin 40 extending toward the outside of the packaging body 10 to the bottom surface 10E of the packaging body. Moreover, the distance H1 from the step surface 12A of the first step portion 12 to the bottom surface 10E of the packaging body is less than the distance H0 from the resin injection portion 11 to the bottom surface 10E of the packaging body.

It will be noted that, as shown in FIG. 2A, a surface of the packaging body 10 opposite to the bottom surface 10E of the packaging body 10 is referred to as a top surface 10F of the packaging body, a direction from the bottom surface 10E of the packaging body to the top surface 10F is referred to as the thickness direction Z of the packaging body, and a direction from the first side 10A of the packaging body to the second side 10B is referred to as the width direction of the packaging body.

It may be understood that the shape of the cavity walls of the cavity 1011 surrounded by the mold 101 will match the outer shape of the packaging body 10 of the power module 100 of the embodiments of the present disclosure. In other words, the cavity 1011 of the mold 101 will have a cavity wall structure corresponding to the outer structure of the packaging body 10.

Therefore, as shown in FIG. 2B, the cavity 1011 of the mold 101 has a first cavity wall step 1012 corresponding to the first step portion 12 of the packaging body 10, and the first cavity wall step 1012 is located on a side of the resin injection opening A proximate to the bottom of the mold. That is to say, a distance H11 from the step surface of the first cavity wall step 1012 to a bottom surface of the cavity is less than a height H01 (i.e., a distance from the resin injection opening A to the bottom surface of the cavity) of the resin injection opening A.

In this way, when the resin is injected into the cavity of the mold through the resin injection opening, the resin first falls on the first cavity wall step 1012, and the first cavity wall step 1012 plays a certain buffering role on the resin, so as to reduce the height at which the resin rushes toward the heat dissipation substrate 60, and reduce the impact force of the resin on the heat dissipation substrate 60 in the inclined downward direction. As a result, the resin may flow to the heat dissipation substrate 60 as smoothly as possible, so that the problem of displacement defects in the heat dissipation substrate 60 may be alleviated and the electrical safety and stability of the power module may be improved.

Moreover, by providing the first cavity wall step 1012, the space (i.e., the space between the heat dissipation substrate 60 and the first cavity wall step 1012) between the heat dissipation substrate 60 and the side of the cavity corresponding to the power pin 40 is reduced, so that the amount of resin accumulated in the space may be reduced when the resin is injected, and the risk of burrs caused by the resin overflowing from the bottom surface of the heat dissipation substrate 60 may be reduced.

Referring to FIG. 2B, the mold 101 has an upper housing and a lower housing, the upper housing and the lower housing are buckled together to form the inner cavity 1011. Therefore, as shown in FIG. 3, a side of the packaging body 10 formed by the mold has a resin parting surface F corresponding to the buckled position between the upper housing and the lower housing of the mold 101.

For example, referring to FIG. 2B, the resin injection opening A may be disposed near the buckled position between the upper housing and the lower housing. For example, the resin injection opening A may be disposed at the buckled position between the upper housing and the lower housing, or the resin injection opening A may be disposed at a position slightly higher than or slightly lower than the buckled position between the upper housing and the lower housing. Correspondingly, for the power module 100, as shown in FIG. 3, the resin injection portion 11 may be located near the resin parting surface F. For example, the resin injection portion 11 may be located above or below the resin parting surface F or be disposed corresponding to the resin parting surface F. Such arrangement may facilitate the processing of the mold.

In some examples, referring to FIG. 2B, the resin injection opening A may be disposed on a side of the mold 101 from which the power pin 40 is led out. That is to say, correspondingly, as shown in FIG. 4, the resin injection portion 11 may be located on the first side 10A of the packaging body 10. In some other examples, the resin injection opening A may be disposed on another side of the mold adjacent to the side of the mold from which the power pin 40 is led out. That is to say, correspondingly, as shown in FIG. 4, the resin injection portion 11 may be located on a side (e.g., a fourth side 10D extending in the width direction Y of the packaging body 10) of the packaging body 10 adjacent to the first side 10A. The embodiments of the present disclosure do not limit this, as long as the resin may be injected into the cavity of the mold 101 through the resin injection opening A to form the packaging body.

In the embodiments of the present disclosure, the heat dissipation substrate 60 may be a double-sided copper-clad ceramic substrate in a one-piece structure, a single-sided copper-clad ceramic substrate, a ceramic substrate, or an insulating heat dissipation copper sheet, and no specific limitation is made herein.

In some examples, as shown in FIG. 2A, the heat dissipation substrate 60 is a double-sided copper-clad ceramic substrate (also referred to as a direct bond copper (DBC) ceramic substrate) in a one-piece structure, including a ceramic plate 61, and a copper layer 62 and another copper layer 63 that are located on two sides of the ceramic plate 61 respectively. The power chip 20 may be disposed on the copper layer 62 of the double-sided copper-clad ceramic substrate. For example, a power pad (not shown in the drawing) may be disposed on the copper layer 62 of the double-sided copper-clad ceramic substrate, and the power chip 20 is disposed on the copper layer 62 of the double-sided copper-clad ceramic substrate through the power pad. The power pin 40 is connected to the copper layer 62. The another copper layer 63 of the double-sided copper-clad ceramic substrate is flush with the bottom surface 10E of the packaging body 10 and exposed outside the packaging body 10. That is to say, a surface of the another copper layer 63 of the double-sided copper-clad ceramic substrate away from the ceramic plate 61 is flush with the bottom surface 10E of the packaging body 10 and exposed outside the packaging body 10. In this embodiment, the double-sided copper-clad ceramic substrate may not only achieve conductive connection to the power chip 20, but also achieve heat conduction to the power chip 20.

In some other examples, as shown in FIG. 2C, the heat dissipation substrate 60 is a single-sided copper-clad ceramic substrate in a one-piece structure, including a ceramic plate 61 and a copper layer 62 located on a side of the ceramic plate 61. The power chip 20 may be disposed on the copper layer 62 of the single-sided copper-clad ceramic substrate. For example, a power pad (not shown in the drawing) may be disposed on the copper layer 62 of the single-sided copper-clad ceramic substrate, and the power chip 20 is disposed on the copper layer 62 of the single-sided copper-clad ceramic substrate through the power pad. The power pin 40 is connected to the copper layer 62. A bottom surface (i.e., a surface of the ceramic plate 61 without the copper layer) of the ceramic plate 61 of the single-sided copper-clad ceramic substrate is flush with the bottom surface 10E of the packaging body 10 and exposed outside the packaging body 10. In this embodiment, the single-sided copper-clad ceramic substrate may not only achieve conductive connection to the power chip 20, but also achieve heat conduction to the power chip 20.

In yet some other examples, as shown in FIG. 2D, the heat dissipation substrate 60 is a ceramic substrate. An upper surface (i.e., a surface proximate to the power chip 20) of the ceramic substrate is attached to a lower surface (i.e., a surface away from the power chip 20) of the second portion 402 of the power pin 40 located in the packaging body 10, and the power chip 20 is disposed on the first portion 401 of the power pin 40 located in the packaging body 10. A bottom surface (i.e., a surface away from the power chip 20) of the ceramic substrate is flush with the bottom surface 10E of the packaging body 10 and exposed outside the packaging body 10. In this embodiment, the second portion 402 of the power pin 40 located in the packaging body 10 serves as a power pad frame to achieve conductive connection with the power chip 20, and combines with the ceramic substrate to achieve heat conduction to the power chip 20. The ceramic substrate may be an entire piece, or may be composed of a plurality of ceramic plates with the same height that are disposed on a side of the power pad frame away from the power chip 20.

In yet some other examples, in the power module 100 as shown in FIG. 2E, the heat dissipation substrate 60 is the double-sided copper-clad ceramic substrate in the one-piece structure as shown in FIG. 2A, and details will not be repeated herein. In this case, the power module 100 further includes a printed circuit board PCB packaged in the packaging body 10, the printed circuit board may be used as a control pad for carrying the control chip 30. That is to say, the control chip 30 is mounted on the printed circuit board PCB. The control pin 50 may be soldered on the printed circuit board PCB.

In some embodiments, as shown in FIG. 2A, the distance H1 from the step surface 12A of the first step portion 12 to the bottom surface 10E of the packaging body is less than the distance H2 from the top surface 20A of the power chip 20 to the bottom surface 10E of the packaging body 10. Correspondingly, as shown in FIG. 2B, the distance H11 from the step surface of the cavity wall step 1012 disposed in the cavity of the mold to the bottom surface of the cavity is less than a distance from the top surface 20A of the power chip 20 to the bottom surface of the cavity.

In this way, when the resin is injected into the cavity through the resin injection opening A, the resin flows to the heat dissipation substrate 60 and the power chip 20 through the cavity wall step 1012. At this time, the resin tends to flow gently toward the heat dissipation substrate 60 in a horizontal direction, which greatly reduces the impact force of the resin on the heat dissipation substrate 60, so that the displacement defects caused by the impact force of the resin on the heat dissipation substrate 60 may be further reduced.

Moreover, in a case where the distance H1 from the step surface 12A of the first step portion 12 to the bottom surface 10E of the packaging body 10 is small, the space between the heat dissipation substrate 60 and the side of the cavity corresponding to the power pin is also small, which may further reduce the amount of resin accumulated in the space, thereby reducing the risk of burrs caused by the resin overflowing from the bottom surface of the heat dissipation substrate 60.

In some embodiments, as shown in FIG. 2C, a distance S from an end portion of the heat dissipation substrate 60 proximate to the power pin 40 to the side 12B of the first step portion 12 is greater than or equal to 0.5 times the thickness H3 of the heat dissipation substrate 60 and less than or equal to 1.5 times the thickness H3 of the heat dissipation substrate 60, that is, 0.5 H3 ≤ S ≤1.5 H3.

For example, the thickness H3 of the heat dissipation substrate 60 may be 1.05 mm.

For example, the distance S from the end portion of the heat dissipation substrate 60 proximate to the power pin 40 to the side 12B of the first step portion 12 satisfies the following: S = 0.5 H3, or S = 1.0 H3, or S = 1.5 H3.

For example, the distance S from the end portion of the heat dissipation substrate 60 proximate to the power pin 40 to the side 12B of the first step portion 12 may be set to 0.869 mm or 1.2 mm.

The distance S from the end portion of the heat dissipation substrate 60 proximate to the power pin 40 to the side 12B of the first step portion 12 is large, and when the resin is injected into the cavity of the mold, the resin may easily fill the space, thereby avoiding the defect of gaps existing in the resin. The distance S from the end portion of the heat dissipation substrate 60 proximate to the power pin 40 to the side 12B of the first step portion 12 is small, and when the resin is injected into the cavity of the mold, the amount of resin accumulated in the space is small, so that the defects of burrs caused by the resin overflowing from the bottom of the heat dissipation substrate 60 may be avoided.

Therefore, in this embodiment, the distance S from the end portion of the heat dissipation substrate 60 proximate to the power pin 40 to the side 12B of the first step portion 12 is set to be greater than or equal to 0.5 times the thickness H3 of the heat dissipation substrate 60 and less than or equal to 1.5 times the thickness H3 of the heat dissipation substrate 60. In this way, when the resin is injected into the cavity of the mold, the resin may easily fill the space between the heat dissipation substrate 60 and the side of the cavity corresponding to the power pin 40, so as to avoid the defect of gaps existing in the resin, and the amount of resin accumulated in the space may also be reduced, so as to avoid burr defects, so that the insulation stability of the power module 100 may be further ensured and the electrical safety of the power module 100 may be improved.

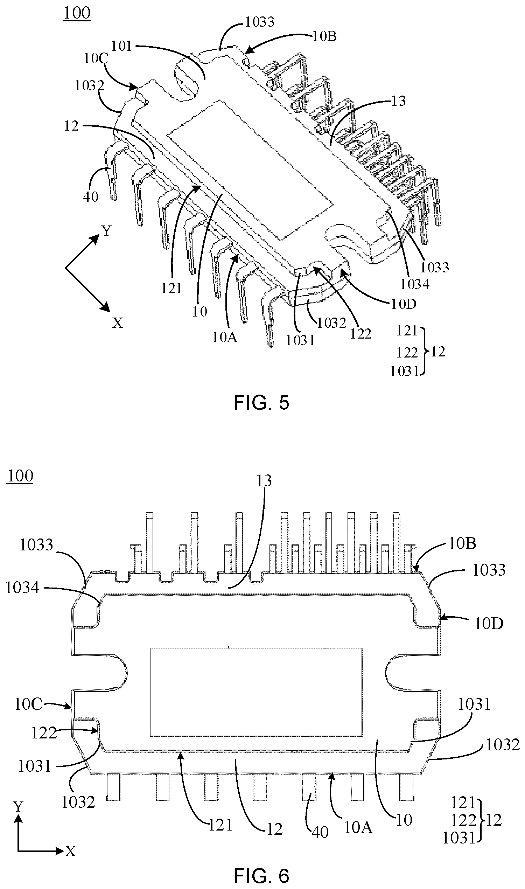

In some embodiments, as shown in FIGS. 5 to 8 and 11, the first step portion 12 includes a main body portion 121 extending in the length direction X of the packaging body 10 and at least one end portion 122 extending in the width direction Y of the packaging body 10. For example, there may be one end portion 122 located on a side of the main body portion 121 in the length direction X of the packaging body 10. For another example, there may be two end portions 122 located on two sides of the main body portion 121 in the length direction X of the packaging body 10, respectively.

In this case, the first step portion 12 further includes a first flow guide portion 1031 connecting the main body portion 121 and the end portion 122 of the first step portion 12. The first flow guide portion 1031 is configured to achieve a function of guiding the resin to flow.

For example, in a case where the first step portion 12 includes only one end portion 122, the first step portion 12 includes only one first flow guide portion 1031. For another example, in a case where the first step portion 12 includes two end portions 122, the first step portion 12 may include two first flow guide portions 1031, and one first flow guide portion 1031 connects one end portion 122 and the main body portion 121.

It may be understood that in a case where the first step portion 12 includes the first flow guide portion 1031, correspondingly, the first cavity wall step in the cavity of the mold forming the packaging body 10 corresponding to the first step portion also has a flow guide structure corresponding to the first flow guide portion 1031.

In this way, when the resin is injected into the cavity, and the resin flows to a corner in the cavity corresponding to the first flow guide portion 1031, the flow guide structure in the cavity corresponding to the first flow guide portion 1031 may provide a component force to guide the resin to an opposite side, so as to improve the fluidity of the resin at this position and guide the resin to flow forward. As a result, it is possible to prevent the resin from stagnating at this position, thereby reducing gaps existing in the resin, and it is also possible to further reduce the amount of resin accumulated at this position, which may further avoid the risk of burrs caused by the resin overflowing from the bottom surface of the heat dissipation substrate 60.

In some examples, the first flow guide portion 1031 may be a chamfer, a convex portion, or a concave portion.

For example, as shown in FIGS. 5 to 8, the first flow guide portion 1031 may be a chamfer. Here, the chamfer may be understood as a surface having a certain angle with the sides of the main body portion 121 and the end portion 122 included by the first step portion 12, and the surface is formed by cutting off sharp edges of a side connecting the main body portion 121 and the end portion 122 included by the first step portion 12.

For the specific arrangement of the angle and side length of the chamfer, as well as the effects generated in a case where the first flow guide portion 1031 is set as the chamfer, reference may be made to the following description of a second flow guide portion 1032, and details will not be described herein.

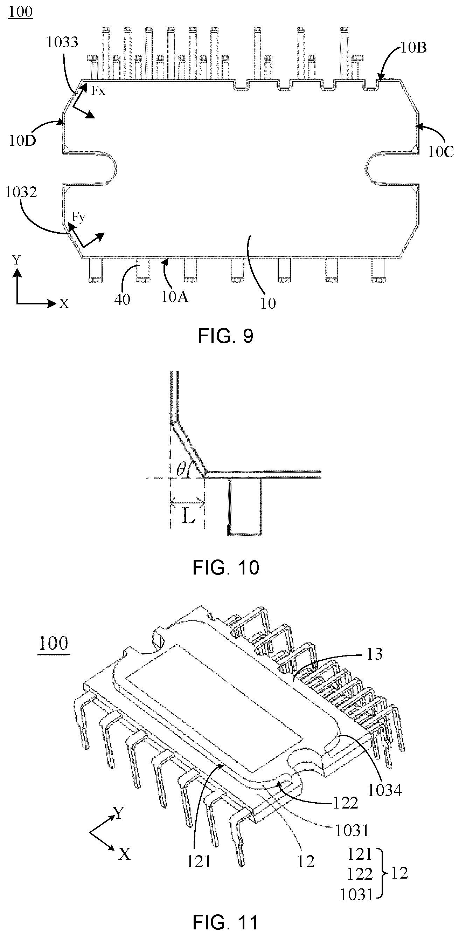

For another example, the first flow guide portion 1031 may be a convex portion or a concave portion. For example, as shown in FIG. 11, the first flow guide portion 1031 is an arc surface whose arc protrudes toward the outside of the packaging body 10.

For the effect generated in a case where the first flow guide portion 1031 is set as the convex portion or the concave portion, reference may be made to the following description of the second flow guide portion 1032, and details will not be described herein.

In some embodiments, as shown in FIGS. 5 to 9, the power module 100 further includes a second flow guide portion 1032. The second flow guide portion 1032 is disposed at a corner of an end portion of a side (i.e., the first side 10A of the packaging body) of the packaging body 10 in the length direction X of the packaging body, and the power pin 40 is led out from the side of the packaging body 10. The second flow guide portion 1032 is configured to achieve a function of guiding the resin to flow.

For example, there may be one second flow guide portion 1032. The second flow guide portion 1032 may be disposed at a corner of an end portion of the first side 10A of the packaging body 10 in the length direction X of the packaging body. That is to say, the second flow guide portion 1032 may be disposed at a corner where the first side 10A is connected with the fourth side 10D. Alternatively, the second flow guide portion 1032 may be disposed at a corner of another end portion of the first side 10A of the packaging body 10 in the length direction X of the packaging body. That is to say, the second flow guide portion 1032 may be disposed at a corner where the first side 10A is connected with the third side 10C (i.e., another side adjacent to the first side 10A except the fourth side 10D).

For another example, as shown in FIGS. 5 to 9, there may be two second flow guide portions 1032, and the two second flow guide portions 1032 are disposed at corners of two end portions of the first side 10A of the packaging body 10 in the length direction X of the packaging body, respectively. That is to say, the two second flow guide portions 1032 are disposed at a corner where the first side 10A is connected with the fourth side 10D and at a corner where the first side 10A is connected with the third side 10C, respectively.

In this way, when the resin is injected, the structure in the cavity corresponding to the second flow guide portion 1032 may provide a component force to guide the resin to the opposite side, so as to improve the fluidity of the resin at this position and guide the resin to flow forward. As a result, it is possible to reduce the stagnation and accumulation of resin at the positions in the cavity corresponding to the corners of the packaging body, and reduce the gaps existing in the resin, so that the electrical safety of the power module may be ensured.

In some examples, as shown in FIGS. 5 to 9, the second flow guide portion 1032 may be a chamfer. Here, the chamfer may be understood as a surface having a certain angle with the first side 10A and the third side 10C (or the fourth side 10D), and the surface is formed by cutting off sharp edges of a side connecting the first side 10A and the third side 10C (or the fourth side 10D).

For example, the resin injection opening is located on a side (i.e., a side corresponding to the first side 10A of the packaging body 10) of the mold from which the power pin is led out, and the resin is injected into the cavity through the resin injection opening. When the resin flows to the position in the cavity corresponding to the second flow guide portion 1032, as shown in FIG. 9, the structure in the cavity corresponding to the chamfer will provide a component force Fy inclined to the opposite side (e.g., the second side 10B) for the resin at this position. As a result, the resin in the cavity that flows to the corner may flow forward, so that the stagnation and accumulation of the resin at the corner may be avoided, and the gaps existing in the resin may be reduced.

It may be seen from the above that the angle of the chamfer may affect the guiding effect of the flow guide portion. For example, as shown in FIG. 10, the angle θ of the chamfer may be greater than or equal to 50°, and less than or equal to 70° (i.e., 50° ≤ θ ≤ 70°). In this way, not only a high guiding capacity of the chamfer may be ensured, but also raw materials may be saved. For example, the angle θ of the chamfer may be 50°, 60° or 70°, and the embodiments of the present disclosure are not limited thereto.

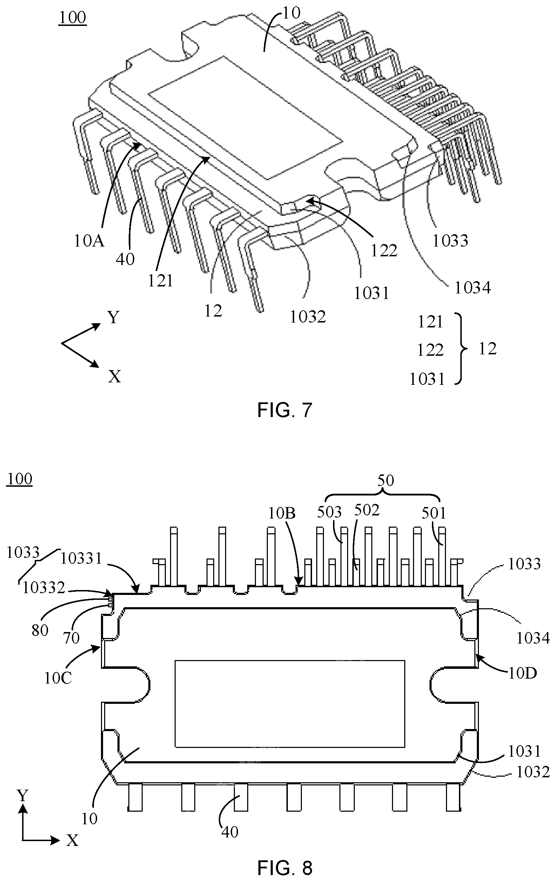

For example, as shown in FIG. 10, a side length L of the chamfer may be greater than 1.2 mm, so as to further improve the guiding capacity of the chamfer. For example, the side length L of the chamfer may be 1.2 mm, 1.4 mm or 1.6 mm, and the embodiments of the present disclosure are not limited thereto. As shown in FIG. 8, the side length L of the chamfer is 1.4 mm.

The second flow guide portion 1032 is disposed at the corner between the first side 10A and the third side 10C (or the fourth side 10D), and the power module is usually installed according to the middle position of the power module in the width direction Y when the power module is used. Therefore, it may be understood that the side length L of the chamfer will not exceed 0.5 times the dimension of the third side 10C (or the fourth side 10D) in the width direction of the packaging body 10.

Similarly, in some other examples, the second flow guide portion 1032 may also be a convex portion. For example, the second flow guide portion 1032 is an arc surface whose arc protrudes toward the outside of the packaging body 10, which may also achieve the effect of guiding the resin at the corner in the cavity corresponding to the second flow guide portion 1032 of the packaging body 10 to flow forward. As a result, it is possible to avoid the stagnation and accumulation of resin at the corner, and reduce the gaps existing in the resin, so that the electrical safety of the power module may be improved.

In yet some other examples, the second flow guide portion 1032 may also be a concave portion. In this way, it is possible to not only achieve the effect of guiding the resin at the corner in the cavity corresponding to the second flow guide portion 1032 of the packaging body 10 to flow forward, but also to avoid stagnation and accumulation of resin at the corner, reduce the gaps existing in the resin, and save raw materials. Of course, the shape of the second flow guide portion 1032 is not limited thereto, and the embodiments of the present disclosure are not limited thereto.

In some embodiments, as shown in FIGS. 5 and 9, the power module 100 further includes a third flow guide portion 1033. The third flow guide portion 1033 may be disposed at a corner of an end portion of a side (i.e., the second side 10B) of the packaging body 10 in the length direction X of the packaging body, and the control pin 50 is led out from the side of the packaging body 10. The third flow guide portion 1033 is configured to achieve a function of guiding the resin to flow.

For example, there may be one third flow guide portion 1033. The third flow guide portion 1033 may be disposed at a corner of an end portion of the second side 10B of the packaging body 10 in the length direction X of the packaging body. That is to say, the third flow guide portion 1033 may be dispose at a corner where the second side 10B is connected with the fourth side 10D. Alternatively, the third flow guide portion 1033 may be disposed at a corner of another end portion of the second side 10B of the packaging body 10 in the length direction X of the packaging body. That is to say, the third flow guide portion 1033 may be dispose at a corner where the second side 10B is connected with the third side 10C.

For another example, as shown in FIGS. 5 to 9, there may be two third flow guide portions 1033, and the two third flow guide portions 1033 are disposed at the corners of two end portions of the second side 10B of the packaging body 10 in the length direction X of the packaging body, respectively. That is to say, the two third flow guide portions 1033 are disposed at a corner where the second side 10B is connected with the fourth side 10D and a corner where the second side 10B is connected with the third side 10C, respectively.

In this way, when the injected resin flows to the corner in the cavity corresponding to the third flow guide portion 1033, the structure in the cavity corresponding to the third flow guide portion 1033 may provide a component force (e.g. the component force Fx in FIG. 9) inclined to the middle portion for the resin flowing toward this position. As a result, the resin flowing to this position may be guided to flow toward the middle portion of the cavity, so that the stagnation and accumulation of the resin at the corner may be reduced, and the gaps existing in the resin may be reduced, and the electrical safety of the power module may be ensured.

In some examples, the third flow guide portion 1033 may be a chamfer, a convex portion, or a concave portion.

For example, as shown in FIGS. 5 and 6, the third flow guide portion 1033 is a chamfer. For the angle and side length of the chamfer, reference may be made to the description of the second flow guide portion 1032, and details will not be repeated herein.

For another example, the third flow guide portion 1033 may also be a convex portion, such as an arc surface (not shown in the drawings) whose arc protrudes toward the outside of the packaging body.

For another example, as shown in FIGS. 7 and 8, the third flow guide portion 1033 is a concave portion. Similarly, the structure in the cavity corresponding to the concave portion may squeeze the resin flowing to the corner, so as to make the resin flow to the middle portion of the cavity, so that the stagnation and accumulation of resin at the corner may be avoided, the gaps existing in the resin may be reduced, and the raw materials may also be saved.

In some embodiments, in a case where the third flow guide portion 1033 is the concave portion, the third flow guide portion 1033 may be one concave portion (e.g., the third flow guide portion 1033 located at the corner between the second side 10B and the fourth side 10D in FIG. 8), or the third flow guide portion 1033 may be two continuous concave portions, namely a first concave portion 10331 and a second concave portion 10332 (e.g., the third flow guide portion 1033 located at the corner between the second side 10B and the third side 10C in FIG. 8).

In some embodiments, as shown in FIGS. 2A, 2C to 2E, the packaging body 10 further includes a recessed second step portion 13, and the second step portion 13 is located on a side of the first portion 501 of the control pin 50 extending toward the outside of the packaging body 10 proximate to the bottom surface 10E of the packaging body.

Here, similar to the recessed first step portion 12, the recessed second step portion 13 means that the second step portion 13 is recessed toward the inside of the packaging body 10. That is to say, the second step portion 13 has a step surface 13A and a side 13B. In the width direction Y of the packaging body 10, the side 13B of the second step portion 13 is closer to the heat dissipation substrate 60 than the second side 10B of the packaging body 10; and in the thickness direction Z of the packaging body 10, the step surface 13A of the second step portion 13 is closer to the first portion 501 of the control pin 50 extending toward the outside of the packaging body 10 than the bottom surface 10E of the packaging body.

In the thickness direction Z of the packaging body 10, a distance H13 from the step surface 13A of the second step portion 13 to the bottom surface 10E of the packaging body is less than a distance H501 from the first portion 501 of the control pin 50 extending toward the outside of the packaging body 10 to the bottom surface 10E of the packaging body.

In some embodiments of the present disclosure, the second step portion 13 is disposed on the side of the first portion 501 of the control pin 50 extending toward the outside of the packaging body 10 proximate to the bottom surface 10E of the packaging body 10. Correspondingly, as shown in FIG. 2B, the cavity 1011 of the mold 101 has a second cavity wall step 1013 corresponding to the second step portion 13 of the packaging body 10. In this way, the arrangement of the second cavity wall step 1013 may reduce the space (i.e., the space between the heat dissipation substrate 60 and the second cavity wall step 1013) between the heat dissipation substrate 60 and a side of the cavity corresponding to the control pin 50, so that the amount of resin accumulated in the space may be reduced, and the risk of burrs caused by the resin overflowing from the bottom surface of the heat dissipation substrate 60 may be further reduced.

In some examples, as shown in FIG. 2A, a height of the second step portion 13 is equal to a height of the first step portion 12. That is to say, in the thickness direction Z of the packaging body 10, the distance H13 from the step surface 13A of the second step portion 13 to the bottom surface 10E of the packaging body is equal to the distance H1 from the step surface 12A of the first step portion 12 to the bottom surface 10E of the packaging body 10.

In some other examples, as shown in FIG. 2C, a depth of the second step portion 13 is equal to a depth of the first step portion 12. That is to say, in the width direction Y of the packaging body 10, a distance D2 from the side 13B of the second step portion 13 to the side (i.e., the second side 10B from which the control pin 50 is led out) of the packaging body 10 is equal to a distance D1 from the side 12B of the first step portion 12 to the side (i.e., the first side 10A from which the power pin is led out) of the packaging body 10.

In some other examples, in the thickness direction Z of the packaging body 10, the distance H13 from the step surface 13A of the second step portion 13 to the bottom surface 10E of the packaging body is equal to the distance H1 from the step surface 12A of the first step portion 12 to the bottom surface 10E of the packaging body 10. Moreover, as shown in FIG. 2C, in the width direction Y of the packaging body 10, the distance D2 from the side 13B of the second step portion 13 to the side (i.e., the second side 10B from which the control pin 50 is led out) of the packaging body 10 is also equal to the distance D1 from the surface 12B of the first step portion 12 to the side (i.e., the first side 10A from which the power pin is led out) of the packaging body 10. That is to say, as shown in FIGS. 2A and 2C to 2E, the second step portion 13 and the first step portion 12 are symmetrically arranged in the width direction Y of the packaging body 10.

Such arrangement not only simplifies the manufacturing process, but also makes the resin easily fill the space between the heat dissipation substrate 60 and the side of the cavity corresponding to the control pin 50, so as to avoid the defect of gaps existing in the resin in this space.

In some embodiments, as shown in FIGS. 2A, 2C to 2E, the packaging body 10 further includes a recessed third step portion 14, and the third step portion 14 is located on a side of the first portion 501 of the control pin 50 extending toward the outside of the packaging body 10 away from the bottom surface 10E of the packaging body.

Here, similar to the recessed first step portion 12, the recessed third step portion 14 means that the third step portion 14 is recessed toward the inside of the packaging body 10. That is to say, the third step portion 14 has a step surface 14A and a side 14B. In the width direction Y of the packaging body, the side 14B of the third step portion 14 is closer to the heat dissipation substrate 60 than the second side 10B of the packaging body; and in the thickness direction Z of the packaging body, the step surface 14A of the third step portion 14 is closer to the first portion 501 of the control pin 50 extending toward the outside of the packaging body 10 than the top surface 10F of the packaging body.

As shown in FIG. 2A, in the thickness direction Z of the packaging body 10, a distance H14 from the step surface 14A of the third step portion 14 to the top surface 10F of the packaging body is less than a distance H502 from the first portion 501 of the control pin 50 extending toward the outside of the packaging body 10 to the top surface 10F of the packaging body.

It will be noted that a surface of the packaging body 10 which is perpendicular to the thickness direction of the packaging body 10 and on which the heat dissipation substrate 60 is not disposed is referred to as the top surface 10F of the packaging body 10.

The side in the cavity where the control pin 50 is disposed is far away from the resin injection opening. Therefore, by providing the second step portion 13 and the third step portion 14 at the positions of the packaging body 10 located on two sides of the first portion 501 of the control pin 50 extending toward the outside of the packaging body 10, respectively, the mold flow speed of the resin on the side in the cavity where the control pin 50 is disposed may be adjusted when the resin is injected. As a result, the mold flow speeds in the entire cavity may be even and the gaps may be avoided, and the resin injection time may also be sped up.

In some examples, as shown in FIGS. 2A, 2C to 2E, the distance H14 from the step surface 14A of the third step portion 14 to the top surface 10F of the packaging body is less than the distance H13 from the step surface 13A of the second step portion 13 to the bottom surface 10E of the packaging body and/or the distance H1 from the step surface 12A of the first step portion 12 to the bottom surface 10E of the packaging body.

In this way, in the premise of ensuring that the resin may completely submerge the control chip 30, the mold flow speed of the resin on the side in the cavity where the control pin is disposed may be further adjusted, so as to make the mold flow speeds in the entire cavity even and avoid the gaps.

In some embodiments, as shown in FIGS. 5 to 8, in a case where the packaging body 10 further includes the recessed second step portion 13, a fourth flow guide portion 1034 is further disposed at a corner of the second step portion 13. The fourth flow guide portion 1034 is configured to achieve a function of guiding the resin to flow.

As shown in FIGS. 6 and 8, the second step portion 13 includes a main body portion 131 extending in the length direction X of the packaging body 10 and at least one end portion 132 extending in the width direction Y of the packaging body 10. In this case, the second step portion 13 further includes the fourth flow guide portion 1034 connecting the main body portion 131 and the end portion 132 of the second step portion 13.

For example, there may be one end portion 132 located on a side of the main body portion 131 in the length direction X of the packaging body 10. In this case, the second step portion 13 includes only one fourth flow guide portion 1034.

For another example, there may be two end portions 132 located on two sides of the main body portion 131 in the length direction X of the packaging body 10, respectively. In this case, the second step portion 13 may include two fourth flow guide portions 1034, and one fourth flow guide portion 1034 connects one end portion 132 and the main body portion 131.

In some examples, the fourth flow guide portion 1034 may be a chamfer, a convex portion, or a concave portion.

For example, as shown in FIGS. 5 to 8, the fourth flow guide portion 1034 may be a chamfer. For the angle and side length of the chamfer, reference may be made to the description of the first flow guide portion 1031 in some embodiments described above, and details will not be repeated herein. For another example, the fourth flow guide portion 1034 may be a convex portion. For example, as shown in FIG. 11, the fourth flow guide portion 1034 is an arc surface whose arc protrudes toward the outside of the packaging body 10.

Similar to the function of the third flow guide portion 1033 in some embodiments described above, when the resin flows to the corner in the cavity corresponding to the fourth flow guide portion 1034, the structure in the cavity corresponding to the fourth flow guide portion 1034 may provide a component force to guide the resin to the middle portion of the cavity. As a result, the resin flows to the middle portion of the cavity, so that the stagnation and accumulation of the resin at the corner may be avoided, and gaps existing in the resin may be reduced.

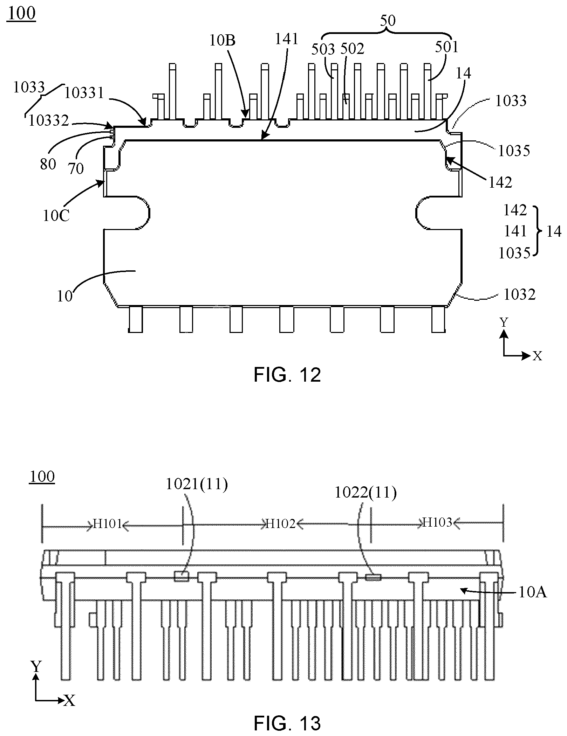

In some embodiments, as shown in FIG. 12, in a case where the packaging body 10 further includes a recessed third step portion 14, a fifth flow guide portion 1035 is further disposed at a corner of the third step portion 14. The fifth flow guide portion 1035 is configured to achieve a function of guiding the resin to flow.

As shown in FIG. 12, the third step portion 14 includes a main body portion 141 extending in the length direction X of the packaging body 10 and at least one end portion 142 extending in the width direction Y of the packaging body 10. In this case, the third step portion 14 further includes the fifth flow guide portion 1035 connecting the main body portion 141 and the end portion 142 of the third step portion 14.

For example, there may be one end portion 142 located on a side of the main body portion 141 in the length direction X of the packaging body 10. In this case, the third step portion 14 includes only one fifth flow guide portion 1035.

For another example, there may be two end portions 132 located on two sides of the main body portion 141 in the length direction X of the packaging body 10, respectively. In this case, the third step portion 14 may include two fifth flow guide portions 1035, and one fifth flow guide portion 1035 connects one end portion 142 and the main body portion 141.

In some examples, as shown in FIG. 12, the fifth flow guide portion 1035 may be a chamfer. For the angle and side length of the chamfer, reference may be made to the description of the second flow guide portion 1032 in some embodiments described above, and details will not be repeated herein.

In some other examples, the fifth flow guide portion 1035 may be a convex portion, such as an arc surface whose arc protrudes toward the outside of the packaging body 10, or the fifth flow guide portion 1035 may be a concave portion.

Similar to the function of the third flow guide portion 1033 in some embodiments described above, when the resin flows to the corner in the cavity corresponding to the fifth flow guide portion 1035, the structure in the cavity corresponding to the fifth flow guide portion 1035 may provide a component force to guide the resin to the middle portion of the cavity. As a result, the resin flows to the middle portion of the cavity, so that the stagnation and accumulation of the resin at the corner may be avoided, and gaps existing in the resin may be reduced.

In the embodiments of the present disclosure, the mold for forming the packaging body 10 by transfer molding may have a plurality of resin injection openings, and the plurality of resin injection openings may be arranged at intervals on a side of the mold from which a plurality of power pins are led out. For example, in the length direction (i.e., the length direction of the packaging body) of the mold, each resin injection opening may be located between two power pins. Correspondingly, in some embodiments, the packaging body 10 has a plurality of resin injection portions 11, and the plurality of resin injection portions 11 may be arranged at intervals on the first side 10A of the packaging body.

For example, as shown in FIG. 13, the packaging body 10 has two resin injection portions 11, such as a first resin injection portion 1021 and a second resin injection portion 1022. In the length direction X of the packaging body 10, the first resin injection portion 1021 and the second resin injection portion 1022 are evenly located on the first side 10A of the packaging body 10. That is to say, in the length direction X of the packaging body 10, a distance H101 between the first resin injection portion 1021 and the corner closest to the first resin injection portion 1021, a distance H102 between the first resin injection portion 1021 and the second resin injection portion 1022, and a distance H103 between the second resin injection portion 1022 and the corner closest to the second resin injection portion 1022 are approximately equal to each other.

In this way, when the resin is injected, the resin may flow evenly to the left side and right side and middle portion of the cavity, which is conducive to the uniformity of resin filling in the cavity and may also achieve the effect of reducing the gaps existing in the resin.

In the power module 100 provided in the embodiments of the present disclosure, there are a plurality of control pins 50, and the plurality of control pins 50 are led out from the second side 10B of the packaging body 10 extending in the length direction X of the packaging body 10. That is to say, the plurality of control pins 50 are arranged along the second side 10B.

In some embodiments, as shown in FIGS. 8, 12, 14 and 16, the power module 100 further includes a first dummy pin 70 led out from the third side 10C of the packaging body 10. The third side 10C is adjacent to the second side 10B and extends in the width direction Y of the packaging body 10.

The plurality of control pins 50 include a first functional pin 501 and a second functional pin 502. In the length direction X of the packaging body 10, the second functional pin 502 is proximate to a middle portion of the second side 10B of the packaging body 10, and the first functional pin 501 is located on a side of the second functional pin 502 away from the first dummy pin 70.

That is to say, the first functional pin 501, the second functional pin 502 and the first dummy pin 70 are substantially arranged evenly in the length direction X of the packaging body 10 in sequence, and led out from different sides of the packaging body 10. Moreover, the first functional pin 501, the second functional pin 502 and the first dummy pin 70 are configured to support the power module 100 from different sides of the power module 100, so as to improve the stability of the power module 100.

In this way, the first functional pin 501, the second functional pin 502 and the first dummy pin 70 may support the entire power module 100 from two sides of the power module 100. As a result, the shaking problem caused by supporting the power module 100 from a single side of the power module 100 may be avoided, the stability of the power module 100 may be improved and the power module 100 may be prevented from being deformed.

Moreover, the first dummy pin 70 is led out from the third side 10C of the packaging body 10, which may avoid increasing the space of the power module 100 in the length direction X that is occupied by the first dummy pin 70 and avoid wasting materials. As a result, it is possible to make the arrangement of the pins used to support the power module 100 reasonable and compact, so that the volume of the power module 100 may be reduced and the miniaturization of the power module 100 may be improved.

In addition, the first functional pin 501 and the second functional pin 502 are led out from the second side 10B of the packaging body 10, and the first dummy pin 70 is led out from the third side 10C of the packaging body 10, which may also increase the insulation distance between these pins, thereby improving the safety performance of the power module 100.

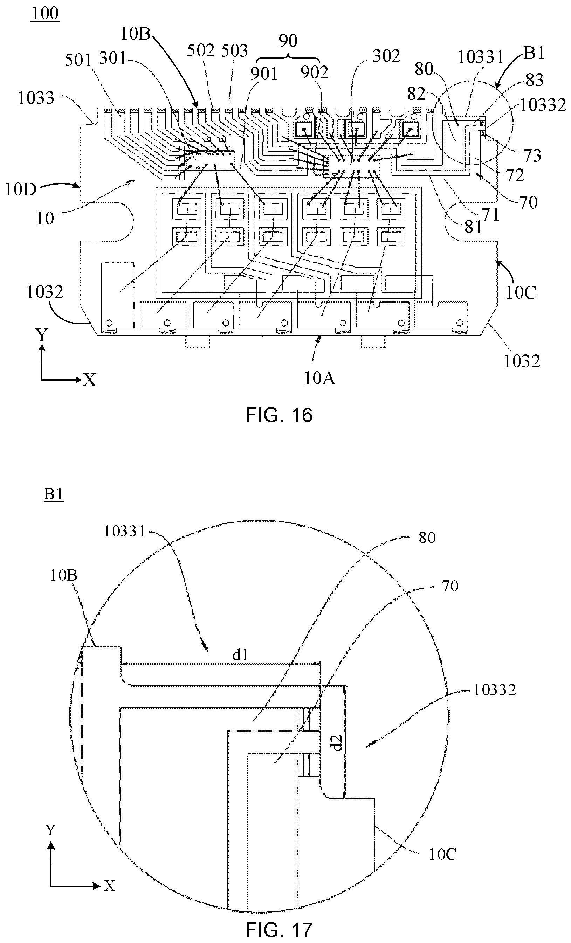

In some embodiments, as shown in FIG. 16, the power module 100 further includes a control pad 90, and the control chip 30 is disposed on the control pad 90. In this way, it is possible to ensure the stability and reliability of the installation of the control chip 30 and improve the performance of the control chip 30.

The first functional pin 501, the second functional pin 502, and the first dummy pin 70 are connected to the control pad 90 as a one-piece structure. Alternatively, it may also be understood that different portions of the control pad 90 form the pad for carrying the control chip 30, the first functional pin 501, the second functional pin 502 and the first dummy pin 70.

The first functional pin 501 and the second functional pin 502 are led out from the second side 10B of the packaging body 10 and each are electrically connected to the peripheral circuit, which not only ensures the normal operation of the power module 100 but also supports the power module 100 and ensures the reliability of the installation of the power module 100. The first dummy pin 70 is led out from the third side 10C of the packaging body 10, so that the power module 100 may be supported by the first dummy pin 70 from a side different from the side from which the control pin 50 is led out, so as to ensure the reliability of the installation of the power module 100.

It may be seen that in the power module 100 provided in some embodiments of the present disclosure, the pads in the power module 100 for mounting the control chip 30 may be used to form pins for supporting the power module 100, there is no need to add additional pins for supporting the power module, so that the space occupied by the pins for supporting the power module may be reduced and the miniaturization of the power module 100 may be improved.

In some embodiments, as shown in FIG. 16, the power module 100 includes a plurality of control chips 30, such as a first control chip 301 and a second control chip 302. According to different uses of the power module 100, the first control chip 301 may be used as a low-voltage chip, and the second control chip may be used as a high-voltage chip, which may improve the operating performance of the power module 100.

In this case, the control pad 90 includes: a first chip pad 901 and a second chip pad 902 that are formed into a one-piece structure. The first chip pad 901 and the second chip pad 902 are connected in sequence along the length direction X of the packaging body 10. The first control chip 301 is disposed on the first chip pad 901, and the second control chip 302 is disposed on the second chip pad 902, which may improve the structural compactness of the power module 100.

In some examples, the first functional pin 501 is electrically connected to the first control chip 301 and may be used to provide a ground voltage to the first control chip 301. The first functional pin 501 is disposed on a side of the first chip pad 901 in the length direction (i.e., the length direction X of the packaging body) of the power module. The first dummy pin 70 is disposed on a side of the second chip pad 902 in the length direction X of the power module away from the first chip pad 901. The second functional pin 502 is disposed proximate to a middle position of the second chip pad 902 of the first chip pad 901. In this way, the first functional pin 501, the second functional pin 502 and the first dummy pin 70 may be distributed evenly in the packaging body 10, so that the supporting force of the first functional pin 501, the second functional pin 502 and the first dummy pin 70 on the power module 100 may be distributed evenly, so as to improve the reliability and stability of the power module 100.

In some embodiments, as shown in FIG. 16, the plurality of control pins 50 further include a third functional pin 503. The third functional pin 503 is electrically connected to the second control chip 302 and may be used to provide a high voltage to the second control chip 302.

In this case, as shown in FIGS. 8, 12, 14 and 16, the power module 100 further includes a second dummy pin 80 led out from the third side 10C of the packaging body 10. The third functional pin 503 is connected with the second dummy pin 80 as a one-piece structure. Moreover, in the length direction X of the packaging body, the third functional pin 503 is located on a side of the second functional pin 502 away from the first functional pin 501 and proximate to the middle portion of the second side 10B of the packaging body 10. That is to say, the third functional pin 503 is disposed proximate to the middle position of the second chip pad 902 of the first chip pad 901.

In this way, the third functional pin 503 and the second dummy pin 80 may also support the power module 100 from two directions, so as to assist the first functional pin 501, the second functional pin 502 and the first dummy pin 70 in supporting the power module 100, so that the stability of the power module 100 may be further improved.

Moreover, the second dummy pin 80 is led out from the side of the power module extending in the width direction (i.e., the width direction Y of the packaging body), which may avoid increasing the space of the power module 100 in the length direction X that is occupied by the second dummy pin 80, so that the volume of the power module 100 is reduced and the miniaturization of the power module 100 may be further improved.

Meanwhile, the third functional pin 503 and the second dummy pin 80 are connected to form a one-piece structure. It may be understood that a pin providing a high voltage to the control chip 30 is used, an end of the pin led out from the second side is used as a high-voltage pin (i.e., the third functional pin 503), and another end of the pin extending in the length direction X of the power module 100 and led out from the third side is used as a non-functional pin (i.e., the second dummy pin 80), and the non-functional pin and the high-voltage pin may support the power module together. In this way, there is no need to add additional pins for supporting the power module, so that the miniaturization of the power module 100 may be further improved while the supporting stability of the power module is ensured.

In the power module 100 provided in some embodiments of the present disclosure, the power module 100 includes the third flow guide portion 1033 located at the corner of the end portion of the second side 10B of the packaging body 10 in the length direction X of the packaging body 10, and the third flow guide portion 1033 includes at least one concave portion. In this way, in the premise of ensuring that the packaging body 10 protects the main structure of the power module 100, not only the volume of the packaging body 10 may be reduced, the resin material required for packaging may be saved, and the production cost of the power module 100 may be reduced, but also the structure of the power module 100 may be compact, the volume of the power module 100 may be reduced, and the miniaturization of the power module 100 may be improved.

In some embodiments, the third flow guide portion 1033 includes one concave portion. In this case, the first dummy pin 70 and the second dummy pin 80 are led out from a side of the concave portion extending in the width direction Y of the packaging body 10.

In some other embodiments, the third flow guide portion 1033 includes two continuous concave portions. As shown in FIGS. 8, 12 and 14 to 18, the third flow guide portion 1033 includes two continuous concave portions, such as a first concave portion 10331 and a second concave portion 10332. The entire first concave portion 10331 extends in the length direction X of the packaging body 10, and the entire second concave portion 10332 extends in the width direction Y of the packaging body 10. In this way, the production process of the packaging body 10 may be simplified and the production difficulty of the packaging body 10 may be reduced.

It may be seen that the second concave portion 10332 is farther away from the control pin 50 than the first concave portion 10331. Therefore, by making the first dummy pin 70 and the second dummy pin 80 led out from a side of the second concave portion 10332 extending in the width direction Y of the packaging body 10, not only the miniaturization of the power module may be improved, but also the insulation length between these pins may be extended.

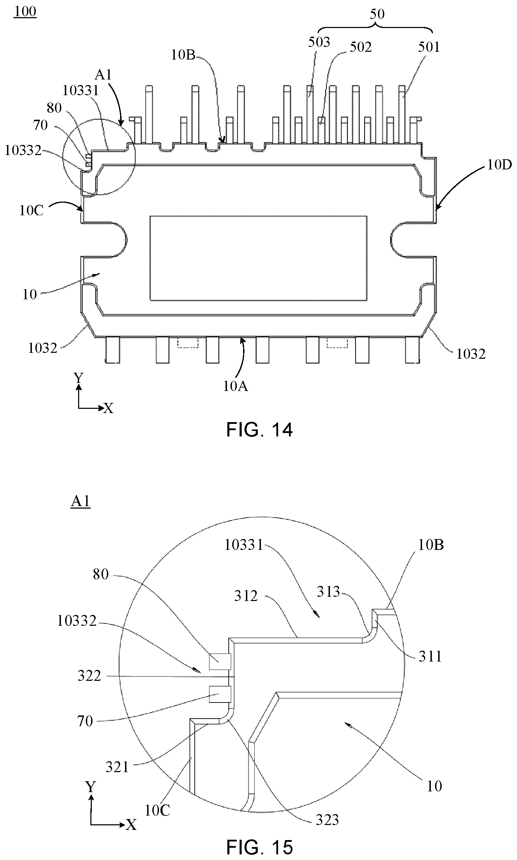

In addition, for example, as shown in FIGS. 14 and 15, lengths of the first dummy pin 70 and the second dummy pin 80 led out of the packaging body 10 do not exceed a depth of the second concave portion 10332. That is to say, in the length direction X of the packaging body 10, end portions of the first dummy pin 70 and the second dummy pin 80 led out of the packaging body 10 do not exceed the third side 10C of the packaging body 10. This not only increases a creepage distance between the first dummy pin 70 and its corresponding functional pin and a creepage distance between the second dummy pin 80 and its corresponding functional pin, but also avoids the electrical contact incidents or damage to the first dummy pin and the second dummy pin caused by the contact between the exposed first dummy pin 70 and second dummy pin 80 and external devices located on a side of the third side 10C of the packaging body 10.

In some examples, as shown in FIG. 17, the first concave portion 10331 and the second concave portion 10332 each are in a shape of a long strip, and a length d1 of the first concave portion 10331 and a length d2 of the second concave portion 10332 satisfy the following relationship: d1 ≥ d2. In this way, the shape design of the first concave portion 10331 and the second concave portion 10332 may be simplified, which may be conducive to molding the first concave portion 10331 and the second concave portion 10332, so that the production difficulty of the packaging body 10 may be further reduced.

Moreover, the lengths of the first concave portion 10331 and the second concave portion 10332 may be matched with the lengths of the first side 10A and the third side 10C where they are correspondingly located, respectively. As a result, the structural design of the packaging body 10 may be further optimized, and the structure of the packaging body 10 may be stable and reliable in the premise of saving the resin material required for packaging and improving the compactness of the structure, so that the structural reliability of the power module 100 may be further improved.

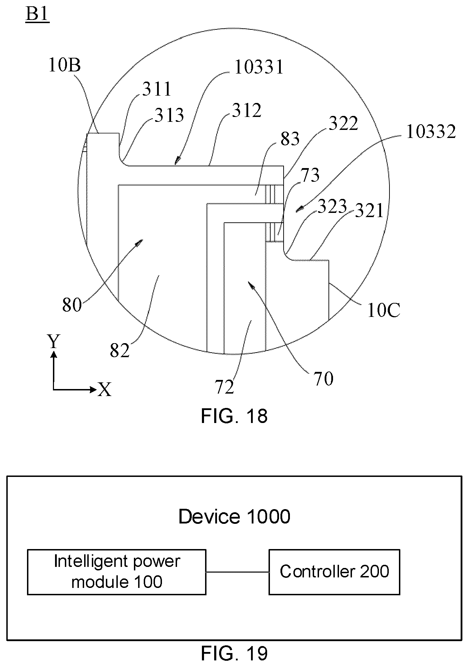

In the power module 100 provided in some embodiments of the present disclosure, as shown in FIGS. 15 and 18, the first concave portion 10331 may mainly include a first sub-side 311 and a second sub-side 312. The first sub-side 311 extends in the width direction Y of the packaging body 10, and the second sub-side 312 extends in the length direction X of the packaging body 10. The first sub-side 311 is connected (e.g., may be vertically connected) between the second sub-side 312 and the second side 10B of the packaging body. A length (i.e., a dimension in the width direction Y of the packaging body 10) of the first sub-side 311 is greater than a length (i.e., a dimension in the length direction X of the packaging body 10) of the second sub-side 312.

The second concave portion 10332 may mainly include a third sub-side 321 and a fourth sub-side 322. The third sub-side 321 extends in the length direction X of the packaging body 10, and the fourth sub-side 322 extends in the width direction Y of the packaging body 10. The third sub-side 321 is connected (e.g., may be vertically connected) between the fourth sub-side 322 and the third side 10C of the packaging body.

In this way, the structures of the first concave portion 10331 and the second concave portion 10332 may be simplified, so as to achieve the long strip structures of the first concave portion 10331 and the second concave portion 10332, and reduce the production difficulty of the third flow guide portion 1033.

For example, as shown in FIGS. 15 and 18, the first concave portion 10331 is further provided with a first transition arc surface 313 between the first sub-side 311 and the second sub-side 312. In this way, the stress distribution at the connection between the first sub-side 311 and the second sub-side 312 of the first concave portion 10331 may be even, so as to prevent the connection between the first sub-side 311 and the second sub-side 312 from breaking due to stress concentration, so that the fatigue safety coefficient of the packaging body 10 at the first concave portion 10331 may be improved, and the structural reliability of the packaging body 10 and even the power module 100 may be improved.

For example, as shown in FIGS. 15 and 18, the second concave portion 10332 is further provided with a second transition arc surface 323 between the third sub-side 321 and the fourth sub-side 322. In this way, the stress distribution at the connection between the third sub-side 321 and the fourth sub-side 322 of the second concave portion 10332 may be even, so as to prevent the connection between the third sub-side 321 and the fourth sub-side 322 from breaking due to stress concentration, so that the fatigue safety coefficient of the packaging body 10 at the second concave portion 10332 may be improved, and the structural reliability of the packaging body 10 and even the power module 100 may be improved.

In some embodiments, the first dummy pin 70 and the second dummy pin 80 each may include a first pin segment, a second pin segment, and a third pin segment connected in sequence.

As shown in FIGS. 16 and 18, the first dummy pin 70 may include a first pin segment 71, a second pin segment 72 and a third pin segment 73 connected in sequence. The first pin segment 71 extends in the length direction X of the packaging body 10; the second pin segment 72 is connected to an end of the first pin segment 71 away from the second control chip 302, and extends in the width direction Y of the packaging body 10; the third pin segment 73 is connected to an end of the second pin segment 72 away from the first pin segment 71, and is bent and extends in the length direction X of the packaging body 10, and an end portion of the third pin segment 73 away from the second pin segment 72 is led out from the third side 10C (e.g., the fourth sub-side 322 of the second concave portion 10332) of the packaging body 10.

The second dummy pin 80 may include a first pin segment 81, a second pin segment 82 and a third pin segment 83 connected in sequence. The connection manner of the first pin segment 81, the second pin segment 82 and the third pin segment 83 of the second dummy pin 80 is similar to the connection manner of the first pin segment 71, the second pin segment 72 and the third pin segment 73 of the first dummy pin 70, and details will not be repeated herein.

In such arrangement, the first dummy pin 70 and the second dummy pin 80 may match the structure of the packaging body 10, which may not only ensure that the first dummy pin 70 and the second dummy pin 80 are led out from the third side 10C (e.g., the fourth sub-side 322 of the second concave portion 10332) of the packaging body 10 and ensure the supporting effect of the first dummy pin 70 and the second dummy pin 80 on the power module 100, but also may make the first dummy pin 70 and the second dummy pin 80 away from the screw fixing grooves on the power module 100 through their first pin segments and second pin segments, so as to avoid a problem that the electrical insulation requirement of the power module 100 cannot be ensured due to interference between the first dummy pin and second dummy pin and the screw fixing grooves or a short distance between the first dummy pin and second dummy pin and the screw, so that the reliability of the power module 100 may be improved.

In some examples, a width of the second pin segment 82 of the second dummy pin 80 is greater than a width of the second pin segment 72 of the first dummy pin 70. Here, the width refers to a dimension in the length direction X of the packaging body 10.

In this way, the second pin segment 82 of the second dummy pin 80 and the second pin segment 72 of the first dummy pin 70 may make full use of the available space on the control pad 90, so as to enhance the structural stability of the second dummy pin 80 and the first dummy pin 70, thereby improving the stability of the supporting effect of the second dummy pin 80 and the first dummy pin 70 on the power module 100.

A device is further provided in some embodiments of the present disclosure, and the power module provided in the embodiments described above is applied to the device.

As shown in FIG. 19, the device 1000 includes a controller 200 and the power module 100 provided in any one of the embodiments, and the power module 100 is connected to the controller 200.

In some embodiments, there may be one or more power modules 100, and the device 1000 may include but is not limited to an inverter or a rectifier. For example, the device 1000 may be a motor drive controller.

For example, the controller 200 may generate a control signal according to user instructions and send the control signal to the power module 100. The power module 100 generates a driving signal according to the control signal and outputs the driving signal to the corresponding driving component, so as to achieve driving control or inversion or rectification conversion.

By adopting the power module 100 of the embodiments described above, the insulation withstand voltage and insulation reliability of the device 1000 provided in the embodiments of the present disclosure are improved, and the electrical safety of the device is improved.

A person skilled in the art will understand that the scope of disclosure in the present disclosure is not limited to the specific embodiments described above, and may modify and substitute some elements of the embodiments without departing from the concept of present disclosure. The scope of the present disclosure is limited by the appended claims.

## Claims

1. A power module, comprising:
a packaging body;
a power chip disposed in the packaging body;
a control chip disposed in the packaging body and electrically connected to the power chip;
a power pin led out from a first side of the packaging body, the power pin being electrically connected to the power chip;
a control pin led out from a second side of the packaging body, the first side and the second side being disposed opposite to each other, and the control pin being electrically connected to the control chip; and
a heat dissipation substrate located in the packaging body, the power chip being disposed on the heat dissipation substrate, and a bottom surface of the heat dissipation substrate being flush with a bottom surface of the packaging body and exposed outside the packaging body; wherein
the packaging body includes a resin injection portion and a first step portion, the first step portion is located on a side of a portion of the power pin extending toward outside of the packaging body proximate to the bottom surface of the packaging body, the first step portion has a step surface and a side; in a width direction of the packaging body, the side of the first step portion is closer to the heat dissipation substrate than the first side of the packaging body; and in a thickness direction of the packaging body, the step surface of the first step portion is closer to the portion of the power pin extending toward the outside of the packaging body than the bottom surface of the packaging body, and a distance from the step surface of the first step portion to the bottom surface of the packaging body is less than a distance from the resin injection portion to the bottom surface of the packaging body.

2. The power module according to claim 1, wherein the distance from the step surface of the first step portion to the bottom surface of the packaging body is less than a distance from a top surface of the power chip to the bottom surface of the packaging body.

3. The power module according to claim 1 or 2, wherein a distance from an end portion of the heat dissipation substrate proximate to the power pin to the side of the first step portion is greater than or equal to 0.5 times a thickness of the heat dissipation substrate and less than or equal to 1.5 times the thickness of the heat dissipation substrate.

4. The power module according to any one of claims 1 to 3, wherein the first step portion includes a main body portion extending in a length direction of the packaging body and an end portion extending in the width direction of the packaging body; wherein the first step portion further includes:
a first flow guide portion connecting the main body portion and the end portion of the first step portion.

5. The power module according to any one of claims 1 to **4,** further comprising:
a second flow guide portion located at a corner of an end portion of the first side of the packaging body in a length direction of the packaging body; and/or
a third flow guide portion located at a corner of an end portion of the second side of the packaging body in the length direction of the packaging body.

6. The power module according to claim 5, wherein the second flow guide portion includes a chamfer, a convex portion or a concave portion; and/or
the third flow guide portion includes a chamfer, a convex portion or at least one concave portion.

7. The power module according to any one of claims 1 to 6, wherein the packaging body further includes a second step portion, the second step portion is located on a side of a portion of the control pin extending toward the outside of the packaging body proximate to the bottom surface of the packaging body; the second step portion has a step surface and a side; in the width direction of the packaging body, the side of the second step portion is closer to the heat dissipation substrate than the second side of the packaging body; and in the thickness direction of the packaging body, the step surface of the second step portion is closer to the portion of the control pin extending toward the outside of the packaging body than the bottom surface of the packaging body.

8. The power module according to claim 7, wherein in the thickness direction of the packaging body, a distance from the step surface of the second step portion to the bottom surface of the packaging body is substantially equal to the distance from the step surface of the first step portion to the bottom surface of the packaging body, and/or, in the width direction of the packaging body, a distance from the side of the second step portion to the side of the packaging body is substantially equal to a distance from the side of the first step portion to the side of the packaging body.

9. The power module according to claim 7 or 8, wherein the second step portion includes a main body portion extending in a length direction of the packaging body and an end portion extending in the width direction of the packaging body; wherein the second step portion further includes:
a fourth flow guide portion connecting the main body portion and the end portion of the second step portion.

10. The power module according to any one of claims 7 to 9, wherein the packaging body further includes a third step portion, the third step portion is located on a side of the portion of the control pin extending toward the outside of the packaging body away from the bottom surface of the packaging body; the third step portion has a step surface and a side; in the width direction of the packaging body, the side of the third step portion is closer to the heat dissipation substrate than the second side of the packaging body; and in the thickness direction of the packaging body, the step surface of the third step portion is closer to the portion of the control pin extending toward the outside of the packaging body than a top surface of the packaging body.

11. The power module according to claim 10, wherein a height from the step surface of the third step portion to the top surface of the packaging body is less than a height from the step surface of the second step portion to the bottom surface of the packaging body and/or a height from the step surface of the first step portion to the bottom surface of the packaging body.

12. The power module according to claim 10 or 11, wherein the third step portion includes a main body portion extending in a length direction of the packaging body and an end portion extending in the width direction of the packaging body; wherein the third step portion further includes:
a fifth flow guide portion connecting the main body portion and the end portion of the third step portion.

13. The power module according to any one of claims 1 to 12, further comprising:
a first dummy pin led out from a third side of the packaging body adjacent to the second side; wherein
the control pin includes a first functional pin and a second functional pin; in a length direction of the packaging body, the second functional pin is proximate to a middle portion of the second side, and the first functional pin is located on a side of the second functional pin away from the first dummy pin; and
the first functional pin, the second functional pin, and the first dummy pin are configured to support the power module from different sides of the power module.

14. The power module according to claim 13, further comprising:
a control pad, the control chip being disposed on the control pad; wherein the first functional pin, the second functional pin and the first dummy pin are connected to the control pad as a one-piece structure; and
a second dummy pin led out from the third side; wherein
the control pin further includes a third functional pin, and in the length direction of the packaging body, the third functional pin is located on a side of the second functional pin away from the first functional pin and proximate to the middle portion of the second side; wherein
the second dummy pin is connected with the third functional pin as a one-piece structure.

15. The power module according to claim 14, wherein in a case where the power module further comprises a third flow guide portion located at a corner of an end portion of the second side of the packaging body in the length direction of the packaging body,
the third flow guide portion includes a concave portion, and the first dummy pin and the second dummy pin are led out from the concave portion; or
the third flow guide portion includes a first concave portion and a second concave portion that are two continuous concave portions, the first concave portion extends in the length direction of the packaging body, and the second concave portion extends in the width direction of the packaging body; the first dummy pin and the second dummy pin both are led out from the second concave portion.

16. The power module according to claim 14 or 15, wherein the first dummy pin and the second dummy pin each include a first pin segment, a second pin segment and a third pin segment connected in sequence; the first pin segment extends in the length direction of the packaging body, the second pin segment extends in the width direction of the packaging body, and the third pin segment extends in the length direction of the packaging body and extends out of the packaging body from the third side of the packaging body.

17. The power module according to claim 16, wherein a width of the second pin segment of the second dummy pin is greater than a width of the second pin segment of the first dummy pin.

18. The power module according to any one of claims 1 to 17, wherein the resin injection portion is located on the first side of the packaging body or a fourth side adjacent to the first side.

19. The power module according to any one of claims 1 to 18, wherein the heat dissipation substrate includes:
a double-sided copper-clad ceramic substrate in a one-piece structure including a ceramic plate and copper layers respectively located on two sides of the ceramic plate; the power chip being disposed on a copper layer of the double-sided copper-clad ceramic substrate, and the power pin being connected to the copper layer, and another copper layer being flush with the bottom surface of the packaging body and exposed outside the packaging body; or
a single-sided copper-clad ceramic substrate in a one-piece structure including the ceramic plate and the copper layer located on a side of the ceramic plate; the power chip being disposed on the copper layer, and the power pin being connected to the copper layer, and a bottom surface of the ceramic plate being flush with the bottom surface of the packaging body and exposed outside the packaging body; or
a ceramic substrate, a portion of the power pin located in the packaging body being attached to the ceramic substrate, the power chip being disposed on a side of the portion of the power pin located in the packaging body away from the ceramic substrate, and the bottom surface of the ceramic substrate being flush with the bottom surface of the packaging body and exposed outside the packaging body.

20. A device comprising a controller and the power module according to any one of claims 1 to 19, the power module being connected to the controller.
